**Europäisches Patentamt**

**European Patent Office**

**Office européen des brevets**

(19)

(11) Veröffentlichungsnummer: **0 334 991 B1**

(12) ## EUROPÄISCHE PATENTSCHRIFT

(45) Veröffentlichungstag der Patentschrift: **04.12.91**

(51) Int. Cl.5: **C03C 17/34**, C23C 14/08

(21) Anmeldenummer: **88113644.4**

(22) Anmeldetag: **23.08.88**

(54) **Verfahren zum Herstellen von Scheiben aus Mineralglas mit hohem Transmissionsverhalten im sichtbaren Spektralbereich und mit niedriger Sonnenenergietransmission sowie durch das Verfahren hergestellte Scheiben.**

(30) Priorität: **26.02.88 DE 3806124**

(43) Veröffentlichungstag der Anmeldung:
**04.10.89 Patentblatt 89/40**

(45) Bekanntmachung des Hinweises auf die Patenterteilung:
**04.12.91 Patentblatt 91/49**

(84) Benannte Vertragsstaaten:
**BE DE FR GB NL SE**

(56) Entgegenhaltungen:
**DE-A- 3 138 998**
**DE-A- 3 611 844**

**APPLIED PHYSICS LETTERS, Band 49, Nr. 23, 8. Dezember 1986, Seiten 1566-1568, American Institute of Physics, New York, US; J.S.E.M. SVENSSON et al.: "Electrochromic hydrated nickel oxide coatings for energy efficient windows: optical properties and coloration mechanism"**

(73) Patentinhaber: **LEYBOLD AKTIENGESELL-SCHAFT**
**Wilhelm-Rohn-Strasse 25**
**W-6450 Hanau am Main 1(DE)**

(72) Erfinder: **Szczyrbowksi, Joachim, Dr.**
**Ringofenstrasse 5**
**W-8758 Goldbach(DE)**
Erfinder: **Rögels, Stefan**
**Rosenstrasse 16**
**W-6455 Erlensee(DE)**
Erfinder: **Dietrich, Anton, Dr.**
**Heilbrunn 16**
**W-8441 Wiesenfelden(DE)**
Erfinder: **Hartig, Klaus, Dr.**
**Hanauerstrasse 17**
**W-6451 Ronneburg 2(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zum Herstellen von Scheiben mit hohem Transmissionsverhalten im sichtbaren Spektralbereich und mit niedriger Sonnenenergietransmission nach dem Oberbegriff des Patentanspruchs 1 sowie eine Scheibe nach dem Oberbegriff des Patentanspruchs 5.

Derartige Scheiben sollen einen möglichst großen Anteil des sichtbaren Lichts durchlassen und einen möglichst großen Anteil der Sonnenstrahlung zurückhalten. Diese Maßnahme soll im Sommer verhindern, daß die unerwünschte Wärmestrahlung des Sonnenlichts in Räume eindringt. Besonders bei Kraftfahrzeugen ist dieser Effekt wegen der schräggestellten und dadurch sehr großen Front- und Heckscheiben besonders unerwünscht.

Durch die DE-OS 33 07 661 und die EP-OS 104 870 ist es bekannt, eine Silberschicht und eine unmittelbar auf das Silber aufgebrachte, sehr dünne Metallschicht zwischen zwei Oxydschichten einzuschließen, wobei die dünne Metallschicht die Silberschicht gegen einen chemisch-thermischen Angriff beim Herstellen der obersten Oxydschicht schützt. Setzt man ein derartiges Schichtsystem jedoch Temperaturen oberhalb 150 $^\circ$C aus, so erfolgt eine Diffusion des Silbers in die angrenzende Oxyd- und/oder Metallschicht, wobei ein starker Anstieg des Flächenwiderstandes und eine entsprechende Verringerung der Transmisionwerte des Schichtsystems zu beobachten ist, d. h. zwei der wesentlichen Eigenschaften des Schichtsystems werden verschlechtert.

Gemäß einem anderen Verfahrens (DOS 35 43 178) wird deshalb empfohlen, auf Substrate aus Mineralglas mittels eines Vakuumbeschichtungsverfahrens ein Mehrschichtsystem aufzubringen, wodurch dem Glas ein hohes Reflexionsverhalten für Wärmestrahlung bei gleichzeitig hohem Transmissionsverhalten für sichtbares Licht verliehen wird. Dabei ermöglicht das aufgebrachte Schichtsystem die zunächst flache, beschichtete Glasscheibe einem Biegeprozeß zu unterziehen, bei dem die Erweichungstemperatur des Glases von ca. 650 $^\circ$C erreicht wird, ohne die Eigenschaften der beschichteten Glasscheibe im negativen Sinne zu verändern. Die so behandelte Glasscheibe weist infolge der Beschichtung einen niedrigen elektrischen Widerstand auf, so daß durch Anlegen einer elektrischen Spannung die Glasscheibe beheizt werden kann.

Werden derartige Scheiben mit einer weiteren unbeschichteten Scheibe zu verbundscheiben in Sandwich-Bauweise, verarbeitet, eignen sie sich insbesondere für den Einsatz in Kraftfahrzeugen als heizbare Front- oder Heckscheibe mit zusätzlicher Schutzfunktion gegen intensive Sonneneinstrahlung. Bei Verbundglasscheiben (VSG-Scheiben) dieser Art befindet sich - ohne Lufteinschluß - zwischen den zwei dünnen Scheiben aus Mineralglas eine zäh-elastische Zwischenlage aus einem Kunststoff (z. B. Polyvinylbutyrat). Bei einer so beschichteten Scheibe steht die beschichtete Seite in direktem Kontakt mit dem Kunststoff. Für den Einsatz derartiger Verbundscheiben in Kraftfahrzeugen ist es aber notwendig, daß die Scheiben bestimmte Mindestwerte für die Transmission des sichtbaren Lichtes erreichen müssen, wobei bestimmte Reflexionswerte für sichtbares Licht nicht überschritten werden dürfen. Dies soll sicherstellen, daß auch bei schlechten Lichtverhältnissen eine ausreichende Sicht durch die Scheibe gewährleistet ist sowie spiegelnde Reflexe in der Scheibe nicht zu einer Sichtbehinderung des Fahrers und zu einer Blendung der entgegenkommenden Fahrzeuge führt. Als zulässiger Grenzwert für die Lichttransmission und -reflexion wird im allgemeinen eine Lichttransmission von 80 ± 5 % gefordert.

Werden nach dem verfahren gemäß der älteren Patentanmeldung (DOS 35 43 178) beschichtete Scheiben zu Verbundglasscheiben verarbeitet, so lassen sich im allgemeinen die in der europäischen Norm geforderten Werte für die Lichttransmission und -reflexion erreichen. Insbesondere werden typischerweise Lichttransmissionswerte von ca. 77 % und -reflexionswerte von 13 bis 14 % erreicht. Die erreichten Transmissionswerte sind dabei für eine Produktion gerade noch ausreichend, da mit Produktionstoleranzen von mindestens ca. + 1 % gerechnet werden muß, was dann immer noch innerhalb der geforderten Grenzen liegt. Die Reflexionswerte sind zwar auch innerhalb der geforderten Grenze, jedoch deutlich höher als z. B. bei unbeschichteten Scheiben oder Wärmeschutzverglasungen, die mit massegefärbtem Glas realisiert werden. Bei derartigen Scheiben liegen die Lichtreflexionswerte bei ca. 8 %, d. h. deutlich niedriger als im Fall der beschichteten Scheiben. Dies führt dazu, daß Teile von Armaturen oder abgelegten Artikeln, die nicht mattschwarz gefärbt sind, in Kraftfahrzeugen sichtbare und störende Reflexe in der Scheibe erzeugen können.

Diese hohen Lichtreflexionswerte sind nun nicht charakteristisch für die beschichteten Scheiben, da die beschichteten, gebogenen Einzelscheiben Reflexionswerte von nur 6 bis 10 % und Lichttransmissionswerte von bis zu 83 % aufweisen. Erst durch das Zusammenfügen dieser beschichteten Scheiben mit einer weiteren unbeschichteten Scheibe mittels einer Laminatfolie ergibt sich ein deutlicher Verlust an Lichttransmission und eine Erhöhung der Reflexion auf Werte um 14 %.

Eine konventionelle Beschichtung, wie sie im Bereich des Architekturglases üblich ist, (Solar-Control-Schichten) besteht im allgemeinen aus dünnen metallischen Schichten, die entweder als Einzelschicht oder eingebettet in Oxydschichten aufgebracht wird. Unterzieht man solche Schichten einer Temperaturbehandlung, so reagieren diese Schichten mit dem Luftsauerstoff und bilden dabei transparente Oxyde, wodurch die ursprüngliche Sonnenschutzfunktion verlorengeht. Andere Schichten, die einer solchen Temperaturbehandlung widerstehen, wie sie z. B. in der DOS 35 43 178 beschrieben wurde, können aufgrund ihrer mechanischen und chemischen Empfindlichkeit nur im Verbund eingesetzt werden, z. B. als Verbundsicherheitsglas oder Isolierglas, bei der die Beschichtung selbst den Umweltbedingungen nicht direkt ausgesetzt ist.

Der Erfindung liegt nun die Aufgabe zugrunde, Scheiben aus Mineralglas - insbesondere aus klaren oder leicht eingefärbten (massegefärbten) Floatgläsern - mit einer dünnen Schicht zu versehen, die die Sonnenenergietransmission gegenüber dem unbeschichteten Glas deutlich verringert. Die Glasscheiben sollen dabei bevorzugt als flache Floatglasscheiben in einer Vakuum-Durchlaufbeschichtungsanlage für Architekturglas mit Hilfe der Hochleistungs-Kathodenzerstäubung beschichtbar sein, so daß sie nach dem Beschichtungsvorgang zu Einscheibensicherheitsglas weiterbearbeitbar sind. Die Eigenschaften der Schicht sollen sich auch nach der Weiterverarbeitung zu einem Einscheibensicherheitsglas nicht nennenswert ändern. Schließlich soll das Verfahren insgesamt preiswert durchführbar sein.

Diese Weiterverarbeitung erfordert, daß die beschichteten Scheiben zugeschnitten sowie einer Temperaturbehandlung von bis zu 640 °C unterzogen werden können. Bei dieser Temperaturbehandlung werden die Scheiben in die endgültige Form gebracht und bei geeigneten Abkühlbedingungen gehärtet. Diese fertigen, gebogenen und gehärteten Gläser sollen dann eine gegenüber normalem klaren oder getöntem Glas reduzierte Transmission für einfallende Sonnenenergie zeigen, wobei aber die Lichttransmission je nach Anwendungsfall bestimmte Grenzwerte nicht unterschreiten darf. So ist z. B. dieser Grenzwert für die Verwendung als Seitenscheibe im vorderen Teil eines Kfz 70 %, für Heckscheiben kann bei Verwendung von entsprechenden Außenspiegeln die Lichttransmission wesentlich weiter abgesenkt werden. Weiterhin muß die Beschichtung mechanische und chemisch sehr beständig sein, da sie ungeschützt,bevorzugt im Innenraum des Fahrzeuges, den Umweltbedingungen ausgesetzt ist und auch entsprechende Reinigungsprozenduren überstehen muß.

Erfindungsgemäß wird diese Aufgabe durch eine auf die Scheibe in einer Beschichtungskammer mit Hilfe einer Kathodenzerstäubung von einem Target aus einer Legierung von 65 % Zinn und 35 % Nickel in einer Atmosphäre mit einem Sauerstoffanteil aufgestäube Schicht gelöst, wobei Scheibe und Schicht anschließend auf eine Temperatur von etwa 640 °C erhitzt werden, wodurch eine stabile und elektrische leitfähige Verbindung bewirkt wird.

Vorzugsweise ist der Anteil des in die Beschichtungskammer eingelassenen Sauerstoffs eine lineare Funktion der in die Kathode eingebrachten Leistung, wobei die Sauerstoffmenge dann richtig eingestellt ist, wenn die optische Transmission der aufgestäubten Schicht nach einer Erhitzung der Schicht auf 640 °C einen Sättigungswert zeigt, und zwar unabhängig von der Behandlungszeit in einem Bereich zwischen 5 und 20 Minuten.

Mit Vorteil wird auf die Zinnoxyd/Nickeloxydschicht eine Schutzschicht aus einem Metalloxyd, beispielsweise Zinnoxyd, Indiumoxyd oder Aluminiumoxyd aufgebracht. Bei einer bevorzugen Ausführungsform wird zwischen dem Substrat und der aus Zinnoxyd und Nickeloxyd gebildeten Schicht eine transparente Metalloxydschicht, beispeilsweise $SnO_2$, $In_2O_3$, $Al_2O_3$ oder $SiO_2$ aufgebracht.

Für besondere Anwendungsfälle, insbesondere bei Kraftfahrzeugen ist eine Scheibe aus Mineralglas mit niedriger Sonnenenergietransmission mit einer auf das Substrat von einem Target aus einer Legierung von 65 % Zinn und 35 % Nickel in einer Atmosphäre mit einem Sauerstoffanteil aufgestäubten Schicht, die nach dem Aufstäuben auf eine Temperatur von etwa 640 °C erhitzt wird, dadurch herstellbar, daß die Scheibe nach der Temperaturbehandlung gebogen wird.

Weitere vorteilhafte Ausgestaltungen des Erfindungsgegenstandes sowie das Verfahrensprodukt sind in den übrigen Unteransprüchen aufgeführt.

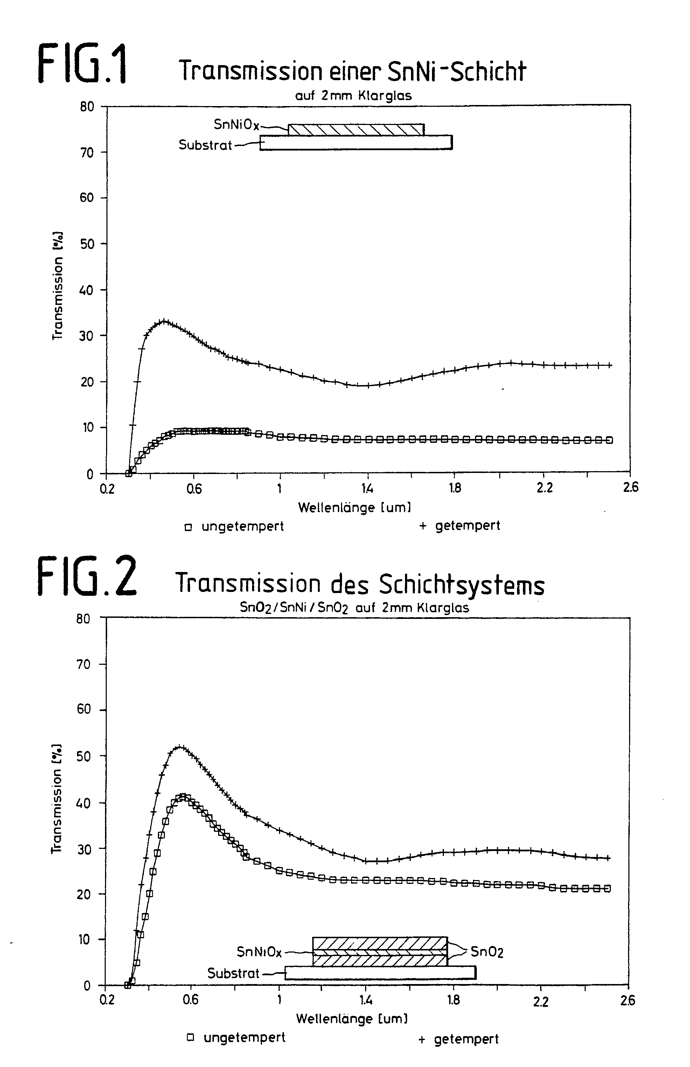

Ein Ausführungsbeispiel des Erfindungsgegenstandes wird nachfolgend anhand der Figuren 1 bis 3 näher erläutert. Es zeigen:

| | |
|---|---|
| Fig. 1 | einen Schnitt durch eine Scheibe mit einer aufgestüubten SnNiOx-Schicht, zusammen mit einer Darstellung der Transmissionskurve |
| Fig. 2 | einen Schnitt durch ein Dreischichtensystem, zusammen mit einer Darstellung der gemessenen Transmission vor und nach der Wärmebehandlung |
| Fig. 3 | ein Schnitt durch ein weiteres Dreischichtensystem, zusammen mit einer Darstellung der gemessenen Transmission vor und nach der Wärmebehandlung |
| Fig. 4 bis 6 | verschiedene Zerstäubungskennlinien für verschiedene Kathodenströme als Funktion des eingelassenen Sauerstoffs für ein SnNi-Target mit markierten Arbeitsbereichen für ver- |

schiedene Schichteigenschaften

Die gestellte Aufgabe läßt sich dadurch lösen, daß mit Hilfe der reaktiven Hochleistungs-Kathodenzerstäubung auf das flache Substrat aus klarem oder leicht grünlich gefärbtem Floatglas eine Schicht aufgestäubt wird, die von einem target mit einer Zusammensetzung von 65 % Zinn und 35 % Nickel abgestäubt wird, wobei in einer Atmosphäre zerstäubt wird, die eine gewisse Menge Sauerstoff enthält. Der Anteil des eingelassenen Sauerstoffs ist eine lineare Funktion der in die Kathode eingebrachten Leistung und muß im Versuch für eine vorgegebene Zerstäubungsanordnung einmal ermittelt werden. Die Sauerstoffmenge ist dann richtig eingestellt, wenn die optische Transmission der aufgestäubten Schicht bei einer Temperaturbehandlung bei ca. 640 °C den gewünschten Sättigungswert erreicht. Für eine aufgestäubte Schicht mit einer Dicke von ca. 90 nm sinkt der spezifische Widerstand von einem Wert von ca. 360 $\mu\Omega cm$ auf ca. 120 $\mu\Omega cm$ durch die Temperaturbehandlung. Bei zu hohem Sauerstoffgehalt der Schicht nach dem Aufstäuben erfolgt im Gegensatz dazu ein sehr starker Anstieg des spezifischen Widerstandes der Schicht sowie ein vollständiges Oxydieren der aufgestäubten Schicht infolge der Temperaturbehandlung, was daran erkenntlich ist, daß die Schicht transparent wird. Dieses Verhalten ist charakteristisch für dünne aufgestäubte oder aufgedampfte metallische Schichten, wenn sie an Luft getempert werden.

Die erwähnte Legierung bildet eine stabile und leitfähige Verbindung, wenn die Schicht nach dem angegebenen Rezept hergestellt wurde un nachfolgend auf Temperaturen von ca. > 640 °C an Luft erhitzt wird. Dies wird dadurch belegt, daß weitere nachfolgende Temperaturbehandlungen keine wesentlichen Änderungen im spezifischen Widerstand und der Transmission der beschichteten Scheibe bewirken, sobald das beschichtete Glas einmal einer Temperbehandlung an Luft unterzogen wurde. Durch dieses Verhalten wird es möglich, daß der Endzustand der beschichteten Scheibe nur wenig von der exakten Dauer und dem Verlauf der Temperaturbehandlung abhängt, d.h. die Transmission und der spezifische Widerstand der beschichteten Scheibe nähern sich im Lauf der Temperaturbehandlung eine Sättigungswert, der bereits durch die Beschichtungsparameter wie Schichtdicke und Sauerstoffgehalt festgelegt wird. Dies ist die Voraussetzung für die Erreichung von reproduzierbaren Eigenschaften der beschichteten Gläser im Produktionsprozeß.

Durch die Temperaturbehandlung erfolgt bei einer richtigen Einstellung der Schichtzusammensetzung bei der Herstellung aber nicht nur ein Abfall im spezifischen Widerstand, sondern es bildet sich auch die gewünschte Charakteristik in der Transmission der Schicht aus, d. h. ein Transmissionsmaximum im sichtbaren Spektralbereich und eine reduzierte Transmission im nahen Infrarotbereich, wie diese aus den entsprechenden Transmissionskurven deutlich wird. Die Transmission des sichtbaren Lichtes der getemperten Scheibe kann nur einfach durch die Dicke der aufgestüubten Schicht eingestellt werden. Für Transmissionswerte von über 50 % im sichtbaren Spektralbereich wird die erwähnte Schicht bevorzugt noch mit einer weiteren transparenten Oxydschicht wie z. B. Zinnoxyd, Indiumzinnoxyd, Aluminiumoxyd etc. überzogen, da damit die mechanische und chemische Widerstandsfähigkeit weiter verbessert wird. Für Schichten unter 50 % Transmission ist die Dicke der SnNi-Suboxydschicht alleine ausreichend.

Eine weitere Herstellungsvariante ist das Einbetten der aktiven SnNi-Suboxydschicht in zwei transparente Oxydschichten aus $SnO_2$, $In_2O_3$, $Al_2O_3$, $SiO_2$ etc. Dadurch ist es möglich, bestimmte erwünschte Farbeffekte zu erzielen bzw. die Reflexion der Beschichtung im sichtbaren Bereich durch Interferenzeffekte zu beeinflussen, in der Art, wie dies bei anderen optischen Schichten für die Architekturbeschichtung häufig angewendet wird.

Eine besondere Ausführungsform ist die Beschichtung von massegefärbtem Glas, insbesondere Grünglas, da durch die Beschichtung die Wärmedämmwirkung dieser Gläser noch wesentlich verstärkt wird bzw. an den entsprechenden Anwendungsfall optimal angepaßt werden kann.

Wesentliche Vorteile dieses Verfahrens sind, daß durch Aufstäuben einer relativ einfachen Schicht (Eine Schicht) einer bestimmten Zusammensetzung durch Ausnutzung des für die weitere Verarbeitung sowieso erforderlichen Temperschrittes die gewünschten Eigenschaften erzielt werden. Da es sich bei der aufgestäubten Schicht nicht um eine reine Metallschicht handelt, die im allgemeinen relativ dünn und dadurch chemisch und mechanische nicht sehr beständig wäre, sondern um eine relativ harte semitransparente Suboxydschicht, aufgebaut aus kommerziell verfügbaren Materialien, können die eingangs erwähnten Anforderungen an die mechanische und chemische Beständigkeit erzielt werden, sowie auch eine kostengünstige Produktion.

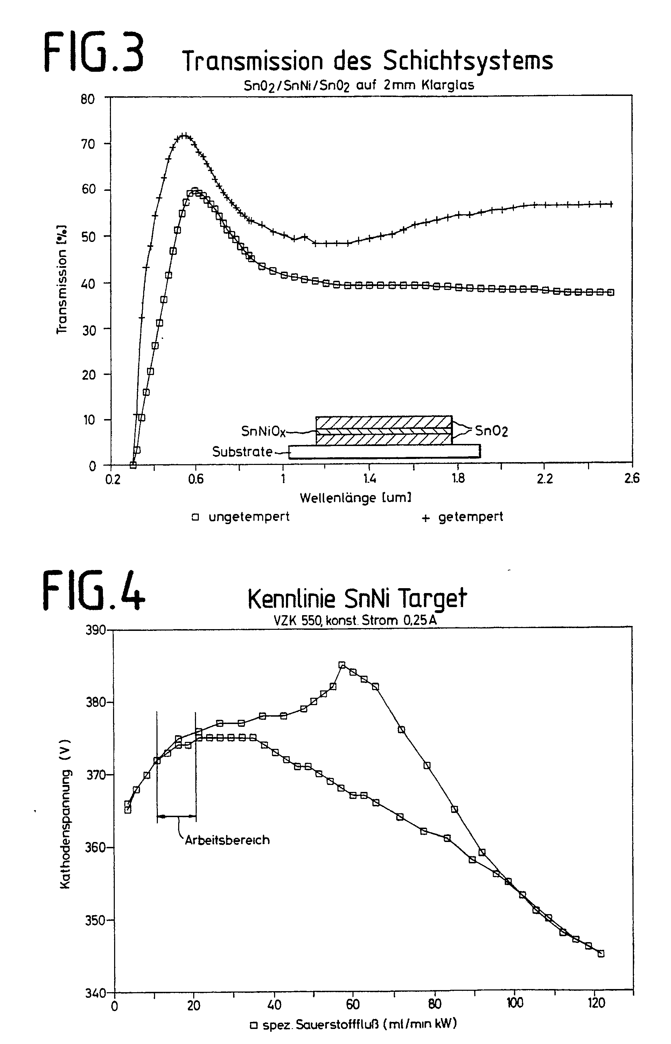

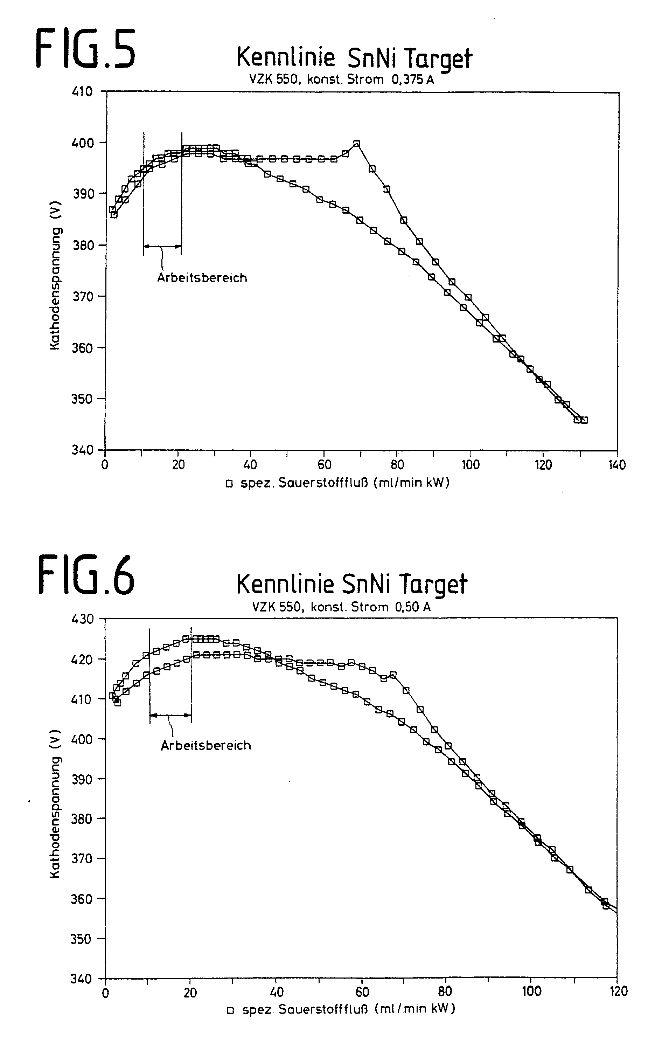

Bei einem typischen Ausführungsbeispiel wurden Floatgläser mit den Abmessungen 2 x 50 x 50 mm in einer Kathodenzerstäubungsanlage mit einer in Argon-Sauerstoffatmosphäre aufgestäubten SnNi-Schicht versehen, wobei die Targetzusammensetzung 65 % Sn und 35 % Ni betrug. Anhand der Kennlinie der Entladung, d. h. dem Verhalten der Spannung der Magnetronentladung bei konstantem Strom als Funktion des über einen Massendurchflußregler eingelassenen Sauerstoffs kann der Bereich definiert werden, der für die angestrebte Schichtzusammensetzung erforderlich ist. Dieser Bereich ist in der graphisch dargestellten Kennlinie markiert (Fig. 4, 5, 6). Es wurden mehrere Schichten unterschiedlicher Dicke aufgestäubt, deren Parameter in der nachfolgenden Tabelle zusammengefaßt sind.

Die Transmission dieser Schichten im sichtbaren und nahen Infrarot-Bereich wurde mit Hilfe eines Spektralphotometers gemessen, und zwar sowohl unmittelbar nach dem Beschichten als auch nach einer Temperaturbehandlung über 5 bzw. 10 Minuten bei 640 °C an Luft. Diese Werte sind in den Figuren 1 bis 3 graphisch dargestellt. Die Dicken der Schichten und die entsprechenden spezifischen Widerstände, die mit Hilfe einer Vierpunkt-Widerstandsmeßeinrichtung und mit Hilfe einer Stylus-Methode gemessen wurden, sind in den nachstehenden drei Tabellen zusammengefaßt.

Es wurde weiterhin auch eine Schicht in der oben angegebenen Art aufgestäubt und auf diese erste Schicht eine weitere transparente Zinnoxydschicht, die durch reaktives Zerstäuben eines Sn-Targets in einer geeigneten Ar-Sauerstoffatmosphäre unmittelbar im Anschluß an die Herstellung der ersten Schicht in der gleichen Beschichtungsanlage aufgebracht wurde. Dieses Schichtpaket wurde ebenfalls der angegebenen Temperaturbehandlung unterzogen. Die gemessenen transmissions-, Widerstands- und Dickenwerte sind ebenfalls in Tabellenform zusammengefaßt.

| Zinn-Nickel (erste Schicht), aufgestäubt mit 3 sccm O$_2$ | | | |
|---|---|---|---|
| | Wärmebehandlung | | |
| | vorher | nachher (640 °C/5 min) | |
| Schichtdicke | 54 nm | 54 nm | |
| spez. Widerstand | 481 $\mu\Omega$/cm | 216 $\mu\Omega$/cm | |
| Lichtdurchlaß | 9 % | 33 % | |

| Schichtsystem Oxyd/SnNi (suboxydisch) 3 sccm O$_2$ /Oxyd | | | |
|---|---|---|---|
| | Wärmebehandlung | | |
| | vorher | nachher (640 °C/5 min) | nachher (640 °C/10 min) |
| Schichtdicke | 27 nm | 27 nm | 27 nm |
| spez. Widerstand | 456 $\mu\Omega$/cm | ca. 270 $\mu\Omega$/cm | ca. 270 $\mu\Omega$/cm |
| Lichtdurchlaß | 40 % | 53 % | 53 % |

| Schichtsystem Oxyd/SnNi (suboxydisch) 3 sccm O$_2$ /Oxyd | | | |
|---|---|---|---|
| | Wärmebehandlung | | |
| | vorher | nachher (640 °C/5 min) | nachher (640 °C/10 min) |
| Schichtdicke | 13,5 nm | 13,5 nm | 13,5 nm |
| spez. Widerstand | 452 $\mu\Omega$/cm | 2,0 $\Omega$/cm | 1,5$\Omega$/cm |
| Lichtdurchlaß | 57 % | 72 % | 72 % |

**Patentansprüche**

1. Verfahren zum Herstellen von Scheiben aus Mineralglas mit hohem Transmissionsverhalten im sichtbaren Spektralbereich und mit niedriger Sonnenenergietransmission, gekennzeichnet durch eine auf die Scheibe in einer Beschichtungskammer mit Hilfe einer Kathodenzerstäubung von einem Target aus einer Legierung von 65 % Zinn und 35 % Nickel in einer Atmosphäre mit einem Sauerstoffanteil aufgestäubte Schicht, wobei Scheibe und Schicht anschließend auf eine Temperatur von etwa 640 °C erhitzt werden, wodurch eine stabile und elektrische leitfähige Verbindung bewirkt wird.

2. Verfahren nach Anspruch 1, dadurch gekennzeichnet, daß die Sauerstoffmenge in der Beschichtungskammer dann richtig eingestellt ist, wenn die optische Transmission der aufgestäubten Schicht nach einer Erhitzung der Schicht auf 640 °C einen Sättigungswert zeigt, unabhängig von der Wärmebehandlungszeit im Bereich von 5 bis 20 Minuten.

3. Verfahren nach den Ansprüchen 1 und 2, dadurch gekennzeichnet, daß auf die Zinnoxyd/Nickeloxydschicht eine Schutzschicht aus einem Metalloxyd, beispielsweise aus Zinnoxyd, Indiumoxyd oder Aluminiumoxyd, aufgebracht wird.

4. Verfahren nach den Ansprüchen 1 bis 3, dadurch gekennzeichnet, daß zwischen der Scheibe und der aus Zinnoxyd und Nickeloxyd gebildeten Schicht eine transparente Metalloxydschicht, beispielsweise aus $SnO_2$, $In_2O_3$, $Al_2O_3$ oder $SiO_2$ aufgebracht wird.

5. Scheibe aus mineralglas mit hohem Transmissionsverhalten im sichtbaren Spektralbereich und mit niedriger Sonnenenergietransmission, gekennzeichnet durch eine auf das Substrat von einem Target aus einer Legierung von 65 % Zinn und 35 % Nickel in einer Atmosphäre mit einem Sauerstoffanteil aufgestäubten Schicht, die nach dem Aufstäuben auf eine Temperatur von etwa 640 °C erhitzt wird, und dadurch, daß die Scheibe nach oder während der Wärmebehandlung gebogen wird.

**Claims**

1. Process for making inorganic glass panes with a high power of transmission in the visible spectrum and a low transmission of solar energy, characterised by a layer composed of an alloy of 65% tin and 35% nickel sprayed on to the pane in a coating chamber by means of cathode sputtering from a target in an atmosphere containing some oxygen, wherein the pane and the layer are then heated to a temperature of approximately 640 °C, whereby a stable and electrically conducting compound is effected.

2. Process according to claim 1, characterised in that the quantity of oxygen in the coating chamber is correct if the optical transmission of the layer sprayed on shows a saturation value after heating of the layer to 640 °C, independently of the heat treatment time within the range of 5 to 20 minutes.

3. Process according to claims 1 and 2, characterised in that a protective layer composed of a metal oxide, e.g. tin oxide, indium oxide or aluminium oxide, is applied to the tin oxide/nickel oxide layer.

4. Process according to claims 1 to 3, characterised in that a transparent metal oxide layer, e.g. composed of $SnO_2$, $In_2O_3$, $Al_2O_3$ or $SiO_2$, is applied between the pane and the layer formed of tin oxide and nickel oxide.

5. Pane of inorganic glass with a high power of transmission in the visible spectrum and a low transmission of solar energy, characterised by a layer sprayed on to the substrate from a target and composed of an alloy of 65% tin and 35% nickel in an atmosphere containing some oxygen, which layer is heated after spraying to a temperature of approximately 640 °C, and in that the pane is curved after or during the heat treatment.

**Revendications**

1. Procédé de fabrication de vitres en verre minéral à haut pouvoir de transmission dans le spectre visible et à faible transmission de l'énergie solaire, caractérisé par une couche apliquée par pulvérisation sur la vitre dans une chambre de revêtement à l'aide d'une pulvérisation cathodique depuis une cible en un alliage de 65 % d'étain et 35 % de nickel dans une atmosphère comportant une proportion d'oxygène, la vitre et la couche étant chauffées ensuite à une température d'environ 640 °C, de sorte qu'il en résulte une liaison stable et électriquement conductrice.

2. Procédé selon la revendication 1, caractérisé en ce que la quantité d'oxygène dans la chambre de revêtement est réglée exactement lorsque la transmission optique de la couche appliquée par pulvérisation présente après un chauffage de la couche à 640 °C une valeur de saturation, indépendamment de la durée du traitement thermique comprise dans la gamme de 5 à 20 min.

3. Procédé selon les revendications 1 et 2, caractérisé en ce qu'une couche de protection en un oxyde métallique, par exemple en oxyde d'étain, oxyde d'indium ou oxyde d'aluminium, est appliquée sur la couche d'oxyde d'étain/oxyde de nickel.

4. Procédé selon les revendications 1 à 3, caractérisé en ce qu'une couche d'oxyde métallique transpa-

rente, par exemple de $SnO_2$, $In_2O_3$, $Al_2O_3$ ou $SiO_2$, est appliquée entre la vitre et la couche constituée par de l'oxyde d'étain et de l'oxyde de nickel.

5. Vitre en verre minéral à haut pouvoir de transmission dans le spectre visible et à faible transmission de l'énergie solaire, caractérisée par une couche appliquée par pulvérisation sur le substrat depuis une cible en un alliage de 65 % d'étain et 35 % de nickel dans une atmosphère comportant une proportion d'oxygène, cette couche étant chauffée à une température de 640°C environ après l'application par pulvérisation, et en ce que la vitre est cintrée après ou pendant le traitement thermique.

# FIG.1 Transmission einer SnNi-Schicht

auf 2mm Klarglas

□ ungetempert          + getempert

# FIG.2 Transmission des Schichtsystems

SnO$_2$/SnNi/SnO$_2$ auf 2mm Klarglas

□ ungetempert          + getempert

# FIG.3 Transmission des Schichtsystems

## SnO$_2$/SnNi/SnO$_2$ auf 2mm Klarglas

Transmission [%] vs Wellenlänge [um]

SnNiO$_x$ — SnO$_2$
Substrate

□ ungetempert          + getempert

# FIG.4 Kennlinie SnNi Target

## VZK 550, konst. Strom 0,25 A

Kathodenspannung (V) vs spez. Sauerstofffluß (ml/min kW)

Arbeitsbereich

# FIG.5

## Kennlinie SnNi Target
### VZK 550, konst. Strom 0,375 A

Kathodenspannung (V) / Arbeitsbereich / □ spez. Sauerstofffluß (ml/min kW)

# FIG.6

## Kennlinie SnNi Target
### VZK 550, konst. Strom 0,50 A

Kathodenspannung (V) / Arbeitsbereich / □ spez Sauerstofffluß (ml/min kW)